# EUROPEAN PATENT SPECIFICATION

(11) **EP 3 605 903 B1**
(45) Date of publication and mention of the grant of the patent: **04.11.2026**
(21) Application number: 18843661.2
(22) Date of filing: 10.08.2018
(51) Int. Cl.: H04L 1/00, H03M 13/27, H03M 13/00, H03M 13/13

(54) **INTERLEAVING METHOD AND DEVICE**
VERSCHACHTELUNGSVERFAHREN UND -VORRICHTUNG
PROCÉDÉ ET DISPOSITIF D'ENTRELAÇAGE

(30) Priority: 11.08.2017 CN 201710687842
(43) Date of publication of application: 05.02.2020
(73) Proprietor: Huawei Technologies Co., Ltd., Longgang District Shenzhen, Guangdong 518129 (CN)
(72) Inventor: CHEN, Ying, Shenzhen Guangdong 518129 (CN); ZHANG, Gongzheng, Shenzhen Guangdong 518129 (CN); LUO, Hejia, Shenzhen Guangdong 518129 (CN); QIAO, Yunfei, Shenzhen Guangdong 518129 (CN); LI, Rong, Shenzhen Guangdong 518129 (CN)
(74) Representative: Pfenning, Meinig & Partner mbB
(86) International application number: PCT/CN2018/100067
(87) International publication number: WO 2019/029726

(56) References cited:
- WO-A1-2015/074192
- WO-A1-2015/123855
- WO-A1-2015/139297
- CN-A- 107 425 941
- US-A1- 2014 208 183
- US-A1- 2019 296 769
- HUAWEI ET AL: "Rate matching for Polar code", vol. RAN WG1, no. Qingdao, China; 20170627 - 20170630, 28 June 2017 (2017-06-28), XP051305952, Retrieved from the Internet <URL:http://www.3gpp.org/ftp/tsg_ran/WG1_RL1/TSGR1_AH/NR_AH_1706/Docs/> [retrieved on 20170628]
- HUAWEI ET AL: "Interleaver design for Polar code", vol. RAN WG1, no. Qingdao, China; 20170627 - 20170630, 26 June 2017 (2017-06-26), XP051299224, Retrieved from the Internet <URL:http://www.3gpp.org/ftp/Meetings_3GPP_SYNC/RAN1/Docs/> [retrieved on 20170626]

## Description

### TECHNICAL FIELD

Embodiments of this application relate to the field of communications technologies, and in particular, to an interleaving method and apparatus.

### BACKGROUND

Rapid evolution of wireless communications indicates that a future 5th generation (5th generation, 5G) communications system will have some new features. Three most typical communication scenarios include an enhanced mobile broadband (enhance mobile broadband, eMBB) scenario, a massive machine type communications (massive machine type communication, mMTC) scenario, and an ultra-reliable and low latency communications (ultra reliable low latency communication, URLLC) scenario. Requirements of these communication scenarios pose new challenges to an existing long term evolution (long term evolution, LTE) technology. As a most basic radio access technology, channel coding is one of important research objects that meet 5G communications requirements. Currently, a 5G standard is being vigorously developed, and a polar code (Polar Codes) is also selected as a control channel coding scheme. The polar code, also referred to as a polar code, is the first and only known channel coding method that can be strictly proved to "achieve" a channel capacity. In different code lengths, especially for a finite code, performance of the polar code is much better than that of a turbo code and a low-density parity-check (low density parity check, LDPC) code. In addition, the polar code has relatively low computational complexity in terms of encoding and decoding. Such advantages enable the polar code to have great development and application prospects in 5G.

To further improve anti-interference performance, an interleaving module is added for some channel coding. On many compound channels on which both a random error and a burst error occur, for example, channels on which shortwave scatter, tropospheric scatter, and the like occur, when an error occurs, a string of data behind is usually affected. Consequently, the burst error is beyond an error-correcting capability of an error-correcting code, decreasing the error-correcting capability. If the burst error is first dispersed into a random error, and then the random error is corrected, the anti-interference performance of a system can be further improved. In an actual application, a digital interleaving unit is connected after an error-correcting encoder at a transmit end, and de-interleaving is performed after demodulation at a receive end. Under action of an interleaving/de-interleaving circuit, a burst error channel is reconstructed into an independent random error channel, and the burst error is expanded to implement error dispersion, so that the burst error is distributed within an error-correcting range of the error-correcting encoder, thereby improving an error-correcting capability of the channel.

HUAWEI ET AL, "Rate matching for Polar code", vol. RAN WG1, no. Qingdao, China; 20170627 - 20170630, (20170628), 3GPP DRAFT; R1-1711702 RATE MATCHING FOR POLAR CODES - REV, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, URL: http://www.3gpp.org/ftp/tsg_ran/WG1_RL1/TSGR1_AH/NR_AH_1706/Docs/, (20170628), XP051305952 proposes a rate matching scheme design for Polar code.

HUAWEI ET AL, "Interleaver design for Polar code", vol. RAN WG1, no. Qingdao, China; 20170627 - 20170630, (20170626), 3GPP DRAFT; R1-1709999 INTERLEAVER DESIGN FOR POLAR CODE, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, URL: http://www.3gpp.org/ftp/Meetings_3GPP_SYNC/RAN1/Docs/, (20170626), XP051299224 discloses an interleaving procedure for Polar code.

Currently, an interleaving design of the polar code cannot be well combined with rate matching. To facilitate the rate matching, an interleaving operation is performed in a rate matching module. To implement randomization of encoded bits, an interleaving module is added for an interleaving operation after the rate matching module, increasing complexity of an implementation process.

### SUMMARY

The above mentioned problems are solved by the method, apparatus, storage medium and computer program product according to the claims.

Embodiments of this application provide interleaving methods and apparatuses according to the independent claims, to reduce complexity of implementation processes of polar code interleaving and rate matching.

According to a first aspect, a computer-implemented interleaving method is provided in independent claim 1.

The interleaving method comprises:
obtaining encoded bits after polar code encoding, and sorting the encoded bits based on a priority order of performing a rate matching operation, to obtain a first bit sequence, wherein the first bit sequence comprises N bits, the first bit sequence comprises j subsequences, and j is a positive integer; and
writing the first bit sequence into an interleaver of i rows and j columns, wherein bits in a column in the interleaver comprise one of the j subsequences, and i is a positive integer; and reading out bits from the interleaver column by column, until M bits are read, wherein M is a target code length of a polar code.

At least two adjacent columns have opposite readout directions. Further, if a manner of the rate matching is puncturing, the priority order of performing the rate matching operation is a descending order of possibility that the encoded bits are punctured, or if the manner of the rate matching is shortening, the priority order of performing the rate matching operation is a descending order of possibility that the encoded bits are shortened.

Additionally, if the manner of the rate matching is puncturing, the reading out bits from the interleaver column by column, until M bits are read comprises: skipping P bit locations starting from the first bit of the first column of the interleaver, and reading out bits other than bits at the P bit locations column by column by starting from a (P+1)^{th} bit, until the M bits are read; and if the manner of the rate matching is shortening, the reading out bits from the interleaver column by column, until M bits are read comprises: skipping P bit locations starting from the last bit of a j^{th} column of the interleaver, and reading out bits other than bits at the P bit locations column by column by starting from a (P+1)^{th} bit, until the M bits are read.

Further, the reading out the bits column by column, until the M bits are read comprises:
reading out the bits column by column in a reading manner of alternating a positive order and a reversal order, until the M bits are read;
wherein the reading manner of the positive order is a top-down reading of a column, and wherein the reading manner of the reversal order is a bottom-up reading of a column; and
wherein the reading manner of alternating the positive order and the reversal order comprises: a reading manner of the reversal order first and then the positive order.

An interleaving apparatus is provided according to independent claim 2.

A computer storage medium is provided in independent claim 3. The computer storage medium stores a computer program, and the computer program includes an instruction used to perform the method according to the first aspect.

A computer program product including an instruction is provided in independent claim 4. When the computer program product is run on a computer, the computer performs the method according to the first aspect.

### BRIEF DESCRIPTION OF DRAWINGS

FIG. 1 is a schematic architectural diagram of a communications system to which an embodiment of this application is applied;
FIG. 2 is a schematic diagram of a procedure performed by an encoding end according to an embodiment of this application;
FIG. 3 is a schematic diagram 1 of a manner of resorting encoded bits according to an embodiment of this application;
FIG. 4 is a schematic diagram 2 of a manner of resorting encoded bits according to an embodiment of this application;
FIG. 5 is a schematic diagram of writing by row into and reading out by column from a row-column interleaver according to an embodiment of this application;
FIG. 6 is a schematic diagram 1 of an interleaving method according to the invention;
FIG. 7 is a schematic diagram 2 of an interleaving method according to an embodiment of this application;
FIG. 8 is a schematic diagram of a buffer-based reading manner according to an embodiment of this application;
FIG. 9 is a schematic diagram 3 of an interleaving method according to an embodiment of this application;
FIG. 10 is a schematic diagram 1 of an interleaving apparatus according to an embodiment of this application;
FIG. 11 is a schematic diagram 2 of an interleaving apparatus according to an embodiment of this application;
FIG. 12 is a schematic diagram 3 of an interleaving apparatus according to an embodiment of this application;
FIG. 13 is a schematic diagram 4 of an interleaving apparatus according to an embodiment of this application;
FIG. 14 is a schematic diagram 5 of an interleaving apparatus according to an embodiment of this application; and
FIG. 15 is a schematic diagram 6 of an interleaving apparatus according to an embodiment of this application.

### DESCRIPTION OF EMBODIMENTS

The following describes in detail embodiments of this application with reference to accompanying drawings.

The embodiments of this application provide an interleaving method and apparatus. A to-be-interleaved bit sequence is written into an interleaver, and M bits are read based on a target code length M obtained through rate matching. Some subsequences are read in a reversal order in a reading process, to achieve interleaving through reading in the reversal order. In this way, compared with the prior art, a simple interleaver design omits a quadratic interleaving operation, greatly reducing implementation complexity. The rate matching is combined with the interleaving, and the rate matching is facilitated. In addition, randomization of encoded bits can also be facilitated.

For ease of understanding of the embodiments of this application, a polar code is briefly described below.

An encoding policy of the polar code is transmitting useful information of a user through a noiseless channel and transmitting agreed information or skipping transmitting information through a pure noisy channel. The polar code is also a linear block code. An encoding matrix of the polar code is *G_{N},* and an encoding process is ${x}_{1}^{N} = {u}_{1}^{N} {G}_{N} ⋅ {u}_{1}^{N} = \left({u}_{1},{u}_{2},…,{u}_{N}\right)$ is a binary row vector and has a length of *N* (that is, a code length). *G_{N}* is an *N*×*N* matrix and *G_{N}* = *F*₂^{⊗(*log*₂(*N*))}*· F*₂^{⊗(*log₂*(*N*))} is defined as a Kronecker (Kronecker) product of log₂ *N* matrices *F*₂. The matrix ${F}_{2} = \left[\begin{matrix}1 & 0 \\ 1 & 1\end{matrix}\right]$.

In the encoding process of the polar code, some bits in *u*₁*^{N}* are used to carry information, and are referred to as an information bit set. A set of indexes of these bits is denoted as A; remaining bits are set to fixed values that are pre-agreed upon by a receive end and a transmit end, and are referred to as a fixed bit set or a frozen bit set (frozen bits). A set of indexes of the remaining bits is represented by a complementary set A^{c} of A. The encoding process of the polar code is equivalent to: ${x}_{1}^{N} = {u}_{A} {G}_{N .} \left(A\right) ⊕ {u}_{{A}^{C}} {G}_{N .} \left({A}^{C}\right)$. Herein, G_{N}(A) is a sub-matrix obtained by rows corresponding to the indexes in the set A in G_{N}, and G_{N}(A^{C}) is a sub-matrix obtained by rows corresponding to the indexes in the set A^{c} in G_{N}. *u_{A}* is the information bit set in *u*₁*^{N}*, and a quantity of *u_{A}* is K. u_{A^{c}} is the fixed bit set in _{*u*1}*^{N}* , a quantity of u_{A^{c}} is N-K, and u_{A^{c}} are known bits. These fixed bits are usually set to 0. However, the fixed bits may be arbitrarily set, provided that the fixed bits are pre-agreed upon by the receive end and the transmit end. In this way, an encoded output of the polar code may be simplified as: ${x}_{1}^{N} = {u}_{A} {G}_{N} \left(A\right)$*.* Herein, *u_{A}* is the information bit set in *u*₁*^{N}*, and *u_{A}* is a row vector having a length of K. In other words, |*A*| *= K.* |·| represents a quantity of elements in a set, K is a size of an information block, *G_{N}*(*A*) is the sub-matrix obtained by the rows corresponding to the indexes in the set A in the matrix *G_{N},* and *G_{N}*(*A*) is a *K*×*N* matrix.

A construction process of the polar code is a selection process of the set A, and determines performance of the polar code. The construction process of the polar code is usually: determining, based on a code length N of a mother code, that there are N polarized channels in total that respectively correspond to N rows of the encoding matrix, calculating reliability of the polarized channels, using indexes of first K polarized channels having higher reliability as elements in the set A, and using indexes corresponding to remaining N-K polarized channels as elements in the set A^{c} of the indexes of the fixed bits. The set A determines locations of the information bits, and the set A^{c} determines locations of the fixed bits.

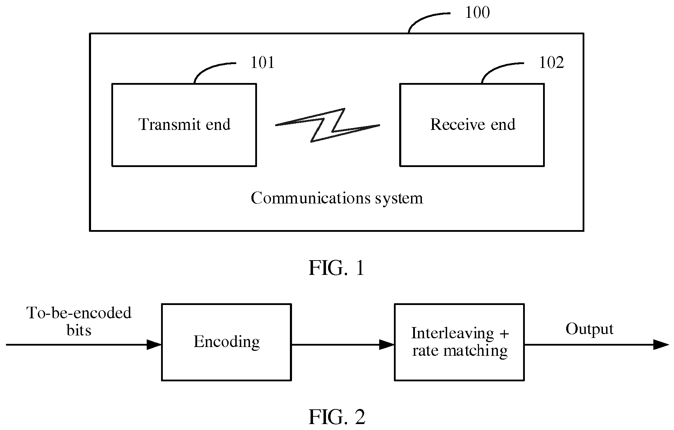

As shown in FIG. 1, a communications system 100 to which an embodiment of this application is applied includes a transmit end 101 and a receive end 102. The transmit end 101 may also be referred to as an encoding end, and the receive end 102 may also be referred to as a decoding end. The transmit end 101 may be a base station, and the receive end 102 may be a terminal. Alternatively, the transmit end 101 is a terminal, and the receive end 102 is a base station. The base station is an apparatus deployed in a radio access network for providing a wireless communication function for the terminal. The base station may include a macro base station, a micro base station, a relay station, an access point, and the like in various forms, and may be applied to systems in different radio access technologies, for example, a long term evolution (long term evolution, LTE) system or more possible communications systems such as a 5th generation (5th generation, 5G) communications system. The base station may alternatively be another network device having a base station function, and particularly, may be a terminal serving as a base station in D2D communication. The terminal may include a handheld device, an in-vehicle device, a wearable device, or a computing device that has a wireless communication function, another processing device connected to a wireless modem, user equipment (user equipment, UE) in various forms, a mobile station (mobile station, MS), and the like.

As shown in FIG. 2, a procedure performed by an encoding end in this application is approximately: Polar code encoding is performed on to-be-encoded information. A specific encoding process is described above. Encoded bits obtained after the polar code encoding are processed, and bits after a processing process are bits after interleaving and rate matching. In the processing process, the encoded bits are first sorted based on a priority order of performing a rate matching operation, to obtain a bit sequence, where the bit sequence herein is referred to as a first bit sequence, and M bits are selected from the first bit sequence based on a target code length M, where M is a positive integer. In a selection process or before the selection, some subsequences in the M bits are sorted in a reversal order. In this way, the rate matching and the interleaving can be implemented in a same module, thereby omitting a step of interleaving a bit sequence after rate matching in the prior art, and reducing implementation complexity.

A priority of performing the rate matching operation is a descending order of possibility that the encoded bits are punctured, or a descending order of possibility that the encoded bits are shortened. Certainly, the priority of performing the rate matching operation is not limited thereto, and locations of the encoded bits may be sorted based on a requirement in an actual application.

The embodiments of this application provide two examples of sorting the encoded bits based on the priority of performing the rate matching operation below.

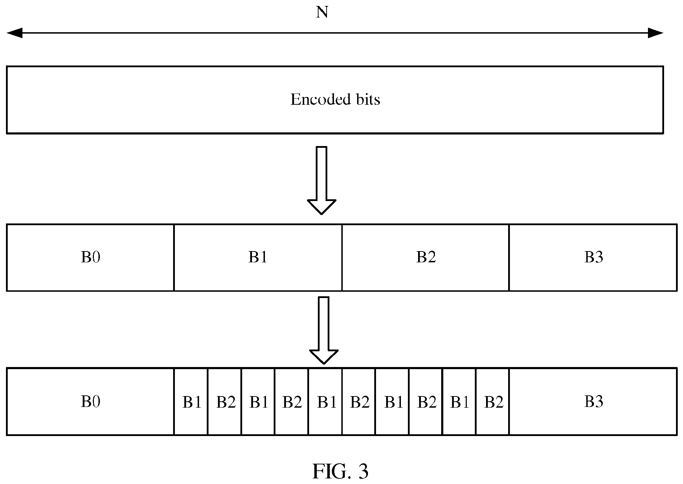

Sorting method 1: As shown in FIG. 3, encoded bits having a length of N are equally divided into four segments in sequence, and the four segments are denoted as B0, B1, B2, and B3. In an application, if the rate matching is performed through puncturing, when a quantity P of puncturing ≤ N/4, puncturing is sequentially performed by starting from the first bit of B0; and when P > N/4, puncturing is performed by alternately selecting bits from B1 and B2 instead of being sequentially performed. If the rate matching is performed through shortening, when a quantity P of puncturing ≤ N/4, puncturing is sequentially performed from back to front by starting from the last bit of B3 (where the puncturing herein is shortening); and when P > N/4, puncturing is performed by alternately selecting bits from B1 and B2 instead of being sequentially performed. To facilitate sequential rate matching, bit locations may be first sorted based on the foregoing priority order before the rate matching, to be specific, bits in B1 and B2 in the encoded bits are crossed bit by bit for interleaving. In this way, the puncturing may be directly performed bit by bit from front to back, and the shortening may be directly performed bit by bit from back to front, to facilitate the rate matching.

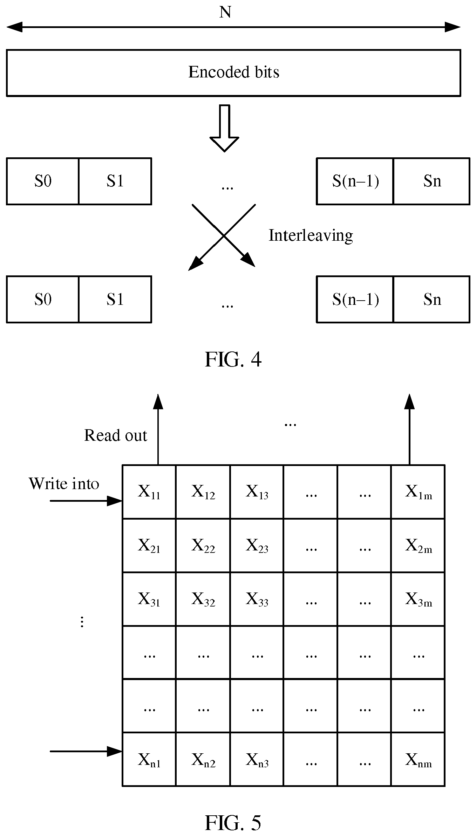

Sorting method 2: As shown in FIG. 4, encoded bits having a length of N are equally divided into S groups, and for example, numbers of the S groups may be 0 to S-1. Locations of the S groups may be sorted. For example, if S is an integral power of 2, the S groups may be sorted based on a reliability sorting sequence of a polar code having a code length of S. The sorting sequence of the polar code includes numbers of polarized channels or reliability values of the polarized channels. In a case, if S is not an integral power of 2, a reliability sorting sequence of first S polarized channels is selected based on a reliability sorting sequence of a polar code having a code length greater than S, and the S groups are sorted based on the reliability sorting sequence of the first S polarized channels. After the S groups are sorted, a sequence having a length of N is obtained through resorting. If the rate matching is performed through puncturing, puncturing is sequentially performed by starting from the first bit of the sequence having a length of N that is obtained through resorting. If the rate matching is performed through shortening, shortening is sequentially performed from back to front by starting from the last bit of the sequence having a length of N that is obtained through resorting.

For example, N = 32, 16 groups are obtained through division by using two bits as a group, and a reliability sorting sequence with a code length of 16 is [0, 1, 2, 4, 8, 3, 5, 6, 9, 10, 12, 7, 11, 13, 14, 15]. If puncturing is performed from front to back based on reliability of the groups, for example, when a quantity of puncturing is 8, blocks 0, 1, 2, and 4 are punctured; or when a quantity of puncturing is 9, blocks 0, 1, 2, and 4 and the first bit of a block 8 are punctured. If shortening is performed from back to front based on reliability of blocks, for example, when a quantity of shortening is 8, blocks 15, 14, and 13 are shortened; or when a quantity of puncturing is 9, blocks 15, 14, and 13 and the last bit of a block 11 are shortened.

An interleaver is used in the solutions designed in the embodiments of this application. For ease of understanding of subsequent content, the interleaver is briefly described below.

Bits to be interleaved by using the interleaver are referred to as to-be-interleaved bits. After the to-be-interleaved bits are written into the interleaver, the bits are read out from the interleaver. A sequence of the bits that are read out changes compared with that of the written bits, to achieve interleaving. A method for writing into and reading from the interleaver may be writing by row and reading by column, writing by column and reading by row, writing by column and reading by column, writing by row and reading by column in a zigzag shape, writing by column and reading by column in a zigzag shape, or the like. The several manners of writing and reading are in the prior art, and details are not described herein. During writing, a quantity of rows may be first fixed, and a quantity of columns, to be specific, a quantity of bits included in each row, is calculated. Alternatively, a quantity of columns may be first fixed, and a quantity of rows, to be specific, a quantity of bits included in each column, is calculated. If the quantity of rows is fixed to i, the quantity of columns is a value obtained after a total length of bits on which row-column interleaving is performed is divided by i and then rounded up. If the quantity of columns is fixed to j, the quantity of rows is a value obtained after a total length of bits on which row-column interleaving is performed is divided by j and then rounded up. During writing by row, the to-be-interleaved bits are written into the interleaver row by row, and a quantity of bits input in each row is the quantity of columns that is calculated by using the foregoing method. If a quantity of bits input in the last row is insufficient, the last row is supplemented by using a null bit. During writing by column, the to-be-interleaved bits are written into the interleaver column by column, and a quantity of bits input in each column is the quantity of rows that is calculated by using the foregoing method. If a quantity of bits input in the last column is insufficient, the last column is supplemented by using a null bit. If the null bit is filled, the null bit needs to be deleted after interleaving. Using the writing by row and reading by column as an example, as shown in FIG. 5, an m*n dimensional matrix is generated based on the to-be-interleaved bits, an operation of writing by row and reading by column is performed on the to-be-interleaved bits based on rows and columns of the matrix, a data input sequence is [X₁₁, X₁₂, X₁₃, ..., X₁ₘ, X₂₁, X₂₂, X₂₃, ..., X₂ₘ, ..., ..., Xₙ₁, Xₙ₂, ..., Xₙₙ], and a data output sequence is [X₁₁, X₂₁, X₃₁, ..., Xₙ₁, X₁₂, X₂₂, X₃₂, ..., Xₙ₂, ..., X₁ₘ, X₂ₘ, X₃ₘ, Xₙₘ], where X₁₁ is a bit of the first row and first column in the interleaver. In an actual application, a size of the interleaver may be determined based on a size of an interleaving matrix formed by using a quantity of rows and a quantity of columns, and interleavers of different quantities of rows and different quantities of columns have different sizes. The size of the interleaver may alternatively be determined based on a size of a memory block that is allocated by a system and that is used for an interleaver application. In this case, the size of the memory block needs to be greater than the size of the matrix formed by using the quantity of rows and the quantity of columns. Interleaving of difference quantities of rows and difference quantities columns occupies resources of different sizes in the memory block. The row or column of the interleaver that is described herein is a row or column in the interleaving matrix formed by using the quantity of rows and the quantity of columns when specific values of the quantity of rows and the quantity of columns are determined. For example, an i^{th} row of the interleaver is an i^{th} row in a determined interleaving matrix of i rows and j columns; and a j^{th} column of the interleaver is a j^{th} column of the determined interleaving matrix of i rows and j columns. When encoded bits are written into a row-column interleaver, and when a quantity N of the encoded bits is less than i * j, zero may be filled.

Based on the same inventive concept, implementations of two interleaving methods are designed in the embodiments of this application, and the two interleaving methods can both achieve the foregoing effect. Based on the architecture of the communications system shown in FIG. 1, an execution body for implementing the interleaving method may be the transmit end 101. The two interleaving methods are described in detail below.

The invention is according to interleaving method 1:

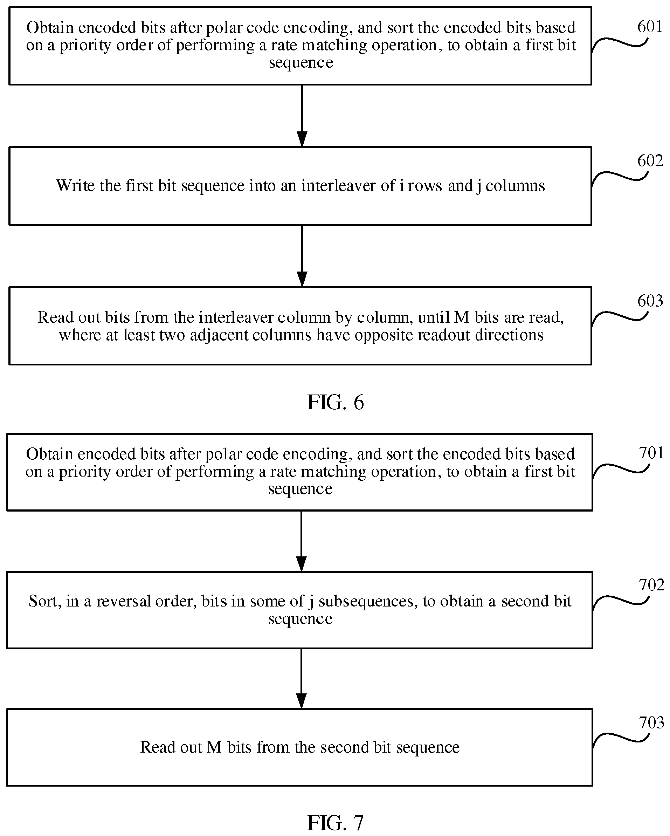

As shown in FIG. 6, a specific procedure of the interleaving method provided in this embodiment of this application is described below.

Step 601. Obtain encoded bits after polar code encoding, and sort the encoded bits based on a priority order of performing a rate matching operation, to obtain a first bit sequence.

The first bit sequence includes N bits, the first bit sequence includes j subsequences, and j is a positive integer. A method for obtaining the first bit sequence may be, but is not limited to, the foregoing sorting method 1 or sorting method 2.

Step 602. Write the first bit sequence into an interleaver of i rows and j columns.

Bits in a column in the interleaver include one of the j subsequences. When the first bit sequence is written into the interleaver of i rows and j columns, if N < (i * j), a null bit may be used to supplement, to be specific, zero is filled.

Specifically, the first bit sequence is written into the interleaver by column bit by bit based on a manner of i rows and j columns, and the first bit sequence occupies a size of an interleaving matrix formed by i rows and j columns in the interleaver.

Step 603. Read out bits from the interleaver column by column, until M bits are read, where at least two adjacent columns have opposite readout directions, and M is a target code length.

Specifically, the interleaving method 1 is writing the first bit sequence into the interleaver and performing writing and reading in a manner of writing by column and reading by column. During the writing, the first bit sequence is sequentially written into the interleaver column by column; and during the reading, it is ensured that at least two adjacent columns of subsequences have opposite readout directions, to achieve interleaving. In addition, the M bits are read based on the target code length M, to achieve the rate matching.

In the following descriptions, the last bit of a j^{th} column of the interleaver may be understood as the last bit of a j^{th} written column of the first bit sequence; and the first bit of the first column of the interleaver may be understood as the first bit of the first written column of the first bit sequence. Such an understanding manner applies to descriptions of this specification.

During the reading, a starting location at which the bits are read is first determined based on a manner of the rate matching.

If the manner of the rate matching is puncturing, the bits are read column by column by starting from the last bit of the j^{th} column of the interleaver, until the M bits are read. In the rate matching manner of puncturing, P bit locations starting from the first bit of the first column of the interleaver are skipped, and bits other than bits at the P bit locations are read out column by column by starting from a (P+1)^{th} bit, until the M bits are read.

If the manner of the rate matching is shortening, P bit locations starting from the last bit of the j^{th} column of the interleaver are skipped, and bits other than bits at the P bit locations are read out column by column by starting from a (P+1)^{th} bit, until the M bits are read.

As described above, in a process of reading column by column, it needs to be ensured that at least two adjacent columns have opposite readout directions, to achieve the interleaving. In the interleaving method, an interleaved reading manner may be, but is not limited to, the following manners: a manner in which n columns are read in a positive order and n columns are read in a reversal order, and a manner in which n columns are read in a positive order and m columns are read in a reversal order, where n and m are both positive integers, and m is not equal to n. For example, the interleaved reading manner may be a manner in which one column is read in a positive order and one column is read in a reversal order, a manner in which two columns are read in a positive order and two columns are read in a reversal order, a manner in which one column is read in a positive order and two columns are read in a reversal order, or a manner in which two columns are read in a positive order and three columns are read in a reversal order.

Using the reading manner in which one column is read in a positive order and one column is read in a reversal order as an example, when the M bits are read, the subsequences are read column by column in a reading manner of alternating the positive order and the reversal order by starting from a starting location determined based on the rate matching manner, until the M bits are read. According to the invention, the reading manner of alternating the positive order and the reversal order includes: a reading manner of the reversal order first and then the positive order. The positive order herein may be understood as being the same as a writing direction, or may be understood as being opposite to the writing direction.

### Interleaving method 2:

As shown in FIG. 7, a specific procedure of the interleaving method provided in this embodiment of this application is described below.

Step 701. Obtain encoded bits after polar code encoding, and sort the encoded bits based on a priority order of performing a rate matching operation, to obtain a first bit sequence.

The first bit sequence includes N bits, the first bit sequence includes j subsequences, and j is a positive integer. A method for obtaining the first bit sequence may be, but is not limited to, the foregoing sorting method 1 or sorting method 2.

Step 702. Sort bits in some of the j subsequences in a reversal order, to obtain a second bit sequence.

Step 703. Select M bits from the second bit sequence and output the M bits.

M is a target code length of a polar code, and M is a positive integer.

In the interleaving method 1, reading orders of difference columns are opposite, to achieve the interleaving. In the interleaving method 2, the bits in the some subsequences in the first bit sequence are sorted in the reversal order and then sequentially read. In both of the two methods, the interleaving and the rate matching can be effectively combined, bit randomization can be implemented by using a simple interleaving design, and the rate matching operation can be facilitated.

Specifically, in the interleaving method 2, bits in at least one of the j subsequences may be sorted in the reversal order. A manner of selecting the subsequence to be sorted in the reversal order may be, but is not limited to, the following manners: selecting a subsequence at intervals of n numbers for sorting in the reversal order, where n is a positive integer; or arbitrarily selecting bits in at least one subsequence for sorting in the reversal order.

An example in which a subsequence is selected at intervals of one subsequence is used. If numbers of the j subsequences are 1 to j, bits in some subsequences that are odd-numbered in the j subsequences are sorted in the reversal order, or bits in some subsequences that are even-numbered in the j subsequences are sorted in the reversal order, to obtain the second bit sequence.

It is assumed that a length of the first bit sequence is 16, and the first bit sequence is represented by {0, 1, 2, 3, 4, 5, 6, 7, 8, 9, 10, 11, 12, 13, 14, 15}. If the first bit sequence is equally divided into four segments, in other words, j = 4, four subsequences are respectively {0, 1, 2, 3}, {4, 5, 6, 7}, {8, 9, 10, 11}, and {12, 13, 14, 15}. After bits in some subsequences that are odd-numbered are sorted in the reversal order, an obtained second bit sequence is {3, 2, 1, 0, 4, 5, 6, 7, 11, 10, 9, 8, 12, 13, 14, 15}; and after bits in some subsequences that are even-numbered are sorted in the reversal order, an obtained second bit sequence is {0, 1, 2, 3, 7, 6, 5, 4, 8, 9, 10, 11, 15, 14, 13, 12}.

After the some subsequences are sorted in the reversal order, compared with the first bit sequence, the second bit sequence is interleaved. The M bits are selected from the second bit sequence by using an interleaver or a buffer, to achieve the rate matching.

If the interleaver is used, the second bit sequence is written into an interleaver of i rows and j columns, and the M bits are read from the interleaver, where bits in a column in the interleaver include one of the j subsequences; and each column has a same reading order.

Similarly, if a manner of the rate matching is puncturing, the M bits are sequentially read by starting from the last bit of a j^{th} column of the interleaver; or P bit locations starting from the first bit of the first column of the interleaver are skipped, and the M bits are sequentially read by starting from a (P+1)^{th} bit.

If a manner of the rate matching is shortening, the M bits are sequentially read by starting from the first bit of the first column of the interleaver; or P bit locations starting from the last bit of a j^{th} column of the interleaver are skipped, and the M bits are sequentially read by starting from a (P+1)^{th} bit.

If the buffer is used, the second bit sequence is input into the buffer bit by bit, and the M bits are read from the buffer.

If a manner of the rate matching is puncturing, the M bits are sequentially read by starting from the last bit in the buffer; or P bit locations starting from the first bit in the buffer are skipped, and the M bits are sequentially read by starting from a (P+1)^{th} bit.

If a manner of the rate matching is shortening, the M bits are sequentially read by starting from the first bit in the buffer; or P bit locations starting from the last bit in the buffer are skipped, and the M bits are sequentially read by starting from a (P+1)^{th} bit.

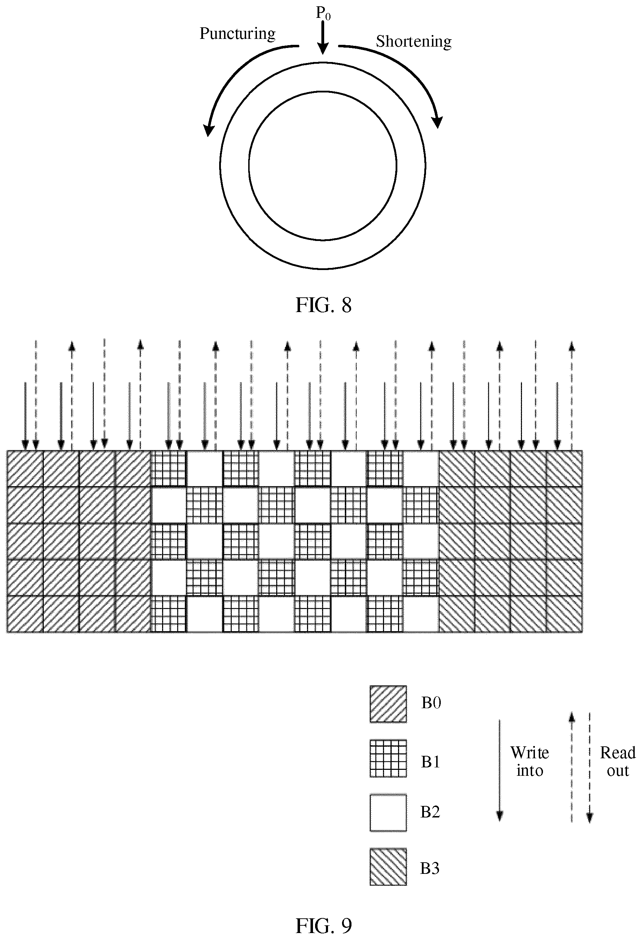

As shown in FIG. 8, the second bit sequence is written into a cyclic buffer by starting from P₀, P₀ is both a starting location and an ending location of the cyclic buffer. If the rate matching manner of puncturing is used, the M bits are read by starting from P₀ in a direction opposite to a writing direction and are used as bits obtained after the rate matching and the interleaving. If the rate matching manner of shortening is used, the M bits are read by starting from P₀ in a direction the same as a writing direction and are used as bits obtained after the rate matching and the interleaving.

It should be noted that in the interleaving method provided in this embodiment of this application, a writing and reading manner when the interleaver is used is writing by column and reading by column. Optionally, a reading manner of writing by row and reading by row may alternatively be used.

In a manner of writing into and reading from the interleaver, if a quantity of rows is fixed to i, a value of i may be a positive odd number or a positive prime number. For example, the quantity i of rows may be selected as 5, 7, 11, or the like.

The foregoing interleaving method is further described in detail below by using an example.

As shown in FIG. 9, assuming that a method for obtaining the first bit sequence is the foregoing sorting method 1, the encoded bits are divided into four segments: B0, B1, B2, and B3, and bits in the second segment B1 and bits in the third segment B2 are crossed bit by bit for interleaving. As shown in FIG. 9, assuming that a length of a first sorting sequence is 80, a length of each segment is 20. The first bit sequence obtained after the interleaving is written into the interleaver column by column in a direction of a solid-line arrow shown in FIG. 9, and the bits in B1 and the bits in B2 are placed in a crossed manner bit by bit. If the rate matching is performed through puncturing, the M bits are sequentially read from back to front by starting from the last bit. This is represented in FIG. 9 as: reading is performed from the last column of the interleaver column by column in a direction of a dashed-line arrow. An interleaved reading manner in FIG. 9 is a manner in which one column is read in a positive order and one column is read in a reversal order.

A decoding procedure at a decoding end in the embodiments of this application is approximately: performing de-interleaving and rate de-matching on a to-be-decoded sequence that is received, and performing polar code decoding on an obtained sequence. Similarly, the decoding end may obtain a de-interleaving mode based on an interleaving mode at an encoding end, and perform a de-interleaving operation based on the obtained de-interleaving mode. Repetitions are not described herein.

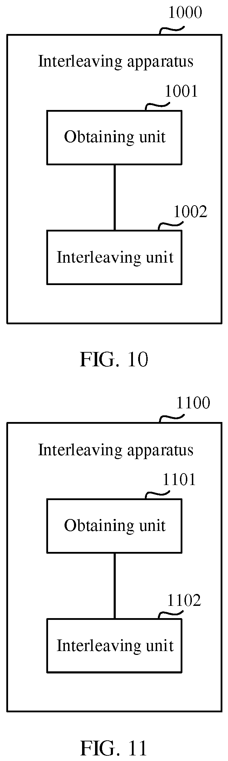

Based on the interleaving method shown in FIG. 6, as shown in FIG. 10, an embodiment of this application further provides an interleaving apparatus 1000. The interleaving apparatus 1000 is configured to perform the method shown in FIG. 6. The interleaving apparatus 1000 includes:
an obtaining unit 1001, configured to obtain encoded bits after polar code encoding, and sort the encoded bits based on a priority order of performing a rate matching operation, to obtain a first bit sequence, where
the first bit sequence includes j subsequences, and j is a positive integer; and
an interleaving unit 1002, configured to write the first bit sequence into an interleaver of i rows and j columns, and read out bits from the interleaver column by column, until M bits are read, where bits in a column in the interleaver include one of the j subsequences, at least two adjacent columns have opposite readout directions, and M is a target code length of a polar code.

According to the invention, if a manner of the rate matching is puncturing, the interleaving unit 1002 is configured to: skip P bit locations starting from the first bit of the first column of the interleaver, and read out bits other than bits at the P bit locations column by column by starting from a (P+1)^{th} bit, until the M bits are read.

According to the invention, if a manner of the rate matching is shortening, the interleaving unit 1002 is configured to: skip P bit locations starting from the last bit of a j^{th} column of the interleaver, and read out bits other than bits at the P bit locations column by column by starting from a (P+1)^{th} bit, until the M bits are read.

According to the invention, the interleaving unit 1002 is configured to: read out the bits column by column in a reading manner of alternating a positive order and a reversal order, until the M bits are read.

The reading manner of alternating the positive order and the reversal order includes: a reading manner of the reversal order first and then the positive order.

Based on the interleaving method shown in FIG. 7, as shown in FIG. 11, an embodiment of this application further provides an interleaving apparatus 1100. The interleaving apparatus 1100 is configured to perform the method shown in FIG. 7. The interleaving apparatus 1100 includes:
an obtaining unit 1101, configured to obtain encoded bits after polar code encoding, and sort the encoded bits based on a priority order of performing a rate matching operation, to obtain a first bit sequence, where the first bit sequence includes N bits, the first bit sequence includes j subsequences, and j is a positive integer; and
an interleaving unit 1102, configured to: sort, in a reversal order, bits in some of the j subsequences obtained by the obtaining unit, to obtain a second bit sequence; and select M bits from the second bit sequence, and output the M bits, where M is a target code length of a polar code, and M is a positive integer.

Optionally, the interleaving unit 1102 is configured to:
if numbers of the j subsequences are 1 to j, perform, in the reversal order, an operation on bits in some subsequences that are odd-numbered in the j subsequences, or perform, in the reversal order, an operation on bits in some subsequences that are even-numbered in the j subsequences, to obtain the second bit sequence.

Optionally, the interleaving unit 1102 is configured to:
write the second bit sequence into an interleaver of i rows and j columns, where bits in a column in the interleaver includes one of the j subsequences; and
read the M bits from the interleaver.

Optionally, if a manner of the rate matching is puncturing, the interleaving unit 1102 is configured to:
sequentially read the M bits by starting from the last bit of a j^{th} column of the interleaver; or
skip P bit locations starting from the first bit of the first column of the interleaver, and sequentially read the M bits by starting from a (P+1)^{th} bit.

Optionally, if a manner of the rate matching is shortening, the interleaving unit 1102 is configured to:
sequentially read the M bits by starting from the first bit of the first column of the interleaver; or
skip P bit locations starting from the last bit of a j^{th} column of the interleaver, and sequentially read the M bits by starting from a (P+1)^{th} bit.

Optionally, the interleaving unit 1102 is configured to: write the second bit sequence into a buffer; and read the M bits from the buffer.

Optionally, if a manner of the rate matching is puncturing, the interleaving unit 1102 is configured to: sequentially read the M bits by starting from the last bit in the buffer; or skip P bit locations starting from the first bit in the buffer, and sequentially read the M bits by starting from a (P+1)^{th} bit.

Optionally, if a manner of the rate matching is shortening, the interleaving unit 1102 is configured to: sequentially read the M bits by starting from the first bit in the buffer; or skip P bit locations starting from the last bit in the buffer, and sequentially read the M bits by starting from a (P+1)^{th} bit.

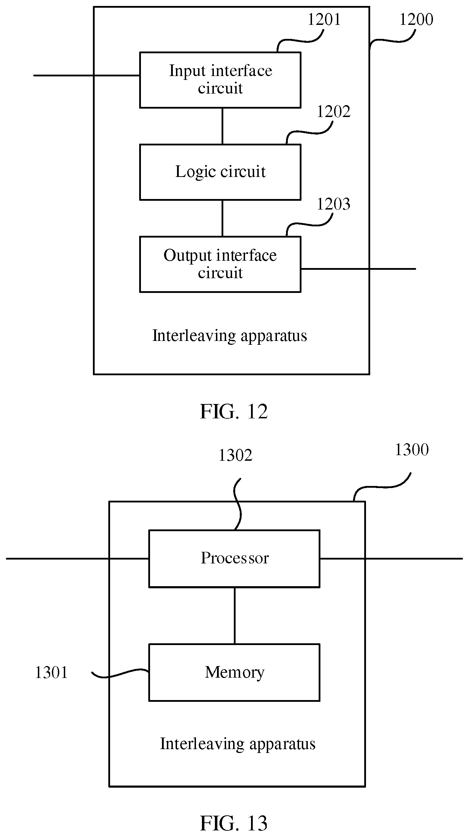

Based on the same inventive concept of the interleaving method shown in FIG. 6, as shown in FIG. 12, an embodiment of this application further provides an interleaving apparatus 1200. The interleaving apparatus 1200 is configured to perform the interleaving method shown in FIG. 6. A part or all of the interleaving method shown in FIG. 6 may be implemented by hardware or may be implemented by software. When the part or all of the interleaving method is implemented by hardware, the interleaving apparatus 1200 includes: an input interface circuit 1201, configured to obtain encoded bits after polar code encoding; a logic circuit 1202, configured to perform a step other than steps of obtaining and outputting the bits in the method shown in FIG. 6, where for details, refer to the descriptions in the foregoing method embodiment, and details are not described herein again; and an output interface circuit 1203, configured to output M bits.

Optionally, the interleaving apparatus 1200 may be a chip or an integrated circuit in a specific implementation.

Optionally, when the part or all of the interleaving method in the foregoing embodiment is implemented by software, as shown in FIG. 13, an interleaving apparatus 1300 includes: a memory 1301, configured to store a program; and a processor 1302, configured to execute the program stored in the memory 1301. When the program is executed, the interleaving apparatus 1300 is enabled to implement the interleaving method provided in the embodiment in FIG. 6.

Optionally, the memory 1301 may be a physically independent unit, or may be integrated with the processor 1302.

Optionally, when the part or all of the interleaving method in the embodiment in FIG. 6 is implemented by software, the interleaving apparatus 1300 may alternatively include only a processor 1302. A memory 1301 configured to store a program is located outside the interleaving apparatus 1300. The processor 1302 is connected to the memory 1301 through a circuit/wire and is configured to read and execute the program stored in the memory 1301.

The processor 1302 may be a central processing unit (central processing unit, CPU), a network processor (network processor, NP), or a combination of a CPU and an NP.

The processor 1302 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable gate array (field-programmable gate array, FPGA), a generic array logic (generic array logic, GAL), or any combination thereof.

The memory 1301 may include a volatile memory (volatile memory), for example, a random-access memory (random-access memory, RAM). Alternatively, the memory 1301 may include a non-volatile memory (non-volatile memory), for example, a flash memory (flash memory), a hard disk drive (hard disk drive, HDD), or a solid-state drive (solid-state drive, SSD). Alternatively, the memory 1301 may include a combination of the foregoing types of memories.

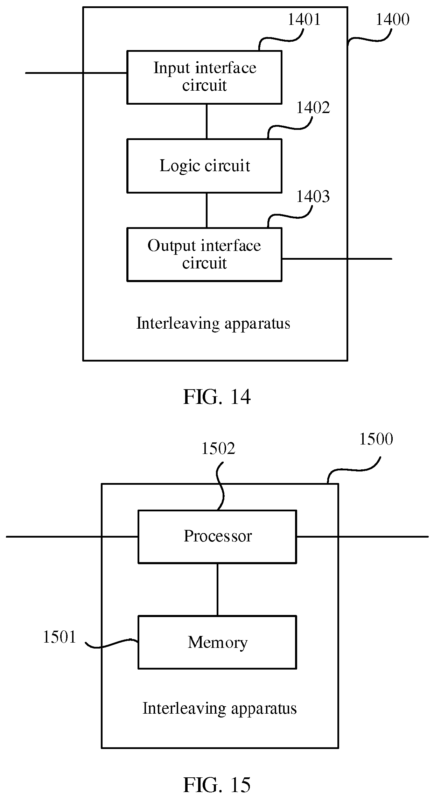

Based on the same inventive concept of the interleaving method shown in FIG. 7, as shown in FIG. 14, an embodiment of this application further provides an interleaving apparatus 1400. The interleaving apparatus 1400 is configured to perform the interleaving method shown in FIG. 7. A part or all of the interleaving method shown in FIG. 7 may be implemented by hardware or may be implemented by software. When the part or all of the interleaving method is implemented by hardware, the interleaving apparatus 1400 includes: an input interface circuit 1401, configured to obtain encoded bits after polar code encoding; a logic circuit 1402, configured to perform a step other than steps of obtaining and outputting the bits in the method shown in FIG. 7, where for details, refer to the descriptions in the foregoing method embodiment, and details are not described herein again; and an output interface circuit 1403, configured to output M bits.

Optionally, the interleaving apparatus 1400 may be a chip or an integrated circuit in a specific implementation.

Optionally, when the part or all of the interleaving method in the foregoing embodiment is implemented by software, as shown in FIG. 15, an interleaving apparatus 1500 includes: a memory 1501, configured to store a program; and a processor 1502, configured to execute the program stored in the memory 1501. When the program is executed, the interleaving apparatus 1500 is enabled to implement the interleaving method provided in the embodiment in FIG. 7.

Optionally, the memory 1501 may be a physically independent unit, or may be integrated with the processor 1502.

Optionally, when the part or all of the interleaving method in the embodiment in FIG. 7 is implemented by software, the interleaving apparatus 1500 may alternatively include only a processor 1502. A memory 1501 configured to store a program is located outside the interleaving apparatus 1500. The processor 1502 is connected to the memory 1501 through a circuit/wire and is configured to read and execute the program stored in the memory 1501.

The processor 1502 may be a central processing unit (central processing unit, CPU), a network processor (network processor, NP), or a combination of a CPU and an NP.

The processor 1502 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable gate array (field-programmable gate array, FPGA), a generic array logic (generic array logic, GAL), or any combination thereof.

The memory 1501 may include a volatile memory (volatile memory), for example, a random-access memory (random-access memory, RAM). Alternatively, the memory 1501 may include a non-volatile memory (non-volatile memory), for example, a flash memory (flash memory), a hard disk drive (hard disk drive, HDD), or a solid-state drive (solid-state drive, SSD). Alternatively, the memory 1501 may include a combination of the foregoing types of memories.

An embodiment of this application further provides a computer storage medium. The computer storage medium stores a computer program, and the computer program includes an instruction used to perform the interleaving method shown in FIG. 6 or FIG. 7.

An embodiment of this application further provides a computer program product including an instruction. When the computer program product is run on a computer, the computer is enabled to perform the interleaving method shown in FIG. 6 or FIG. 7.

Persons skilled in the art should understand that the embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to the embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a special-purpose computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer readable memory that can instruct the computer or any other programmable data processing device to work in a specific manner, so that the instructions stored in the computer readable memory generate an artifact that includes an instruction apparatus. The instruction apparatus implements a specific function in one or more processes in the flowcharts and/or in one or more blocks in the block diagrams.

These computer program instructions may be loaded onto a computer or another programmable data processing device, so that a series of operations and steps are performed on the computer or the another programmable device, thereby generating computer-implemented processing. Therefore, the instructions executed on the computer or the another programmable device provide steps for implementing a specific function in one or more processes in the flowcharts and/or in one or more blocks in the block diagrams.

Although some preferred embodiments of this application have been described, persons skilled in the art can make changes and modifications to these embodiments once they learn the basic inventive concept. Therefore, the following claims are intended to be construed as to cover the preferred embodiments and all changes and modifications falling within the scope of these claims.

Apparently, persons skilled in the art can make various modifications and variations to the embodiments of this application without departing from the scope of the claims. This application is intended to cover these modifications and variations provided that they fall within the scope of protection defined by the following claims.

## Claims

1. A computer-implemented interleaving method, comprising:
obtaining (601) encoded bits after polar code encoding, and sorting (601) the encoded bits based on a priority order of performing a rate matching operation, to obtain a first bit sequence, wherein the first bit sequence comprises N bits, the first bit sequence comprises j subsequences, and j is a positive integer; and
writing (602) the first bit sequence into an interleaver of i rows and j columns, wherein bits in a column in the interleaver comprise one of the j subsequences, and i is a positive integer; and reading out (603) bits from the interleaver column by column, until M bits are read, wherein M is a target code length of a polar code;
wherein if a manner of the rate matching is puncturing, the priority order of performing the rate matching operation is a descending order of possibility that the encoded bits are punctured, or if the manner of the rate matching is shortening, the priority order of performing the rate matching operation is a descending order of possibility that the encoded bits are shortened;
wherein at least two adjacent columns have opposite readout directions;
wherein if the manner of the rate matching is puncturing, the reading out (603) bits from the interleaver column by column, until M bits are read comprises: skipping P bit locations starting from the first bit of the first column of the interleaver, and reading out bits other than bits at the P bit locations column by column by starting from a (P+1)^{th} bit, until the M bits are read; and
wherein if the manner of the rate matching is shortening, the reading out (603) bits from the interleaver column by column, until M bits are read comprises: skipping P bit locations starting from the last bit of a j^{th} column of the interleaver, and reading out bits other than bits at the P bit locations column by column by starting from a (P+1)^{th} bit, until the M bits are read;
wherein the reading out (603) the bits column by column, until the M bits are read comprises:
reading out the bits column by column in a reading manner of alternating a positive order and a reversal order, until the M bits are read;
wherein the reading manner of the positive order is a top-down reading of a column, and wherein the reading manner of the reversal order is a bottom-up reading of a column; and
wherein the reading manner of alternating the positive order and the reversal order comprises: a reading manner of the reversal order first and then the positive order.

2. An interleaving apparatus (1000), comprising:
an obtaining unit (1001), configured to obtain encoded bits after polar code encoding, and sort the encoded bits based on a priority order of performing a rate matching operation, to obtain a first bit sequence, wherein the first bit sequence comprises N bits, the first bit sequence comprises j subsequences, and j is a positive integer; and
an interleaving unit (1002), configured to: write the first bit sequence into an interleaver of i rows and j columns, wherein bits in a column in the interleaver comprise one of the j subsequences; and
read out bits from the interleaver column by column, until M bits are read, wherein M is a target code length of a polar code;
wherein if a manner of the rate matching is puncturing, the priority order of performing the rate matching operation is a descending order of possibility that the encoded bits are punctured, or if the manner of the rate matching is shortening, the priority order of performing the rate matching operation is a descending order of possibility that the encoded bits are shortened;
wherein at least two adjacent columns have opposite readout directions;
wherein if the manner of the rate matching is puncturing, the interleaving unit (1002) is configured to skip P bit locations starting from the first bit of the first column of the interleaver, and reading out bits other than bits at the P bit locations column by column by starting from a (P+1)^{th} bit, until the M bits are read; and
wherein if the manner of the rate matching is shortening, the interleaving unit (1002) is configured to skip P bit locations starting from the last bit of a j^{th} column of the interleaver, and reading out bits other than bits at the P bit locations column by column by starting from a (P+1)^{th} bit, until the M bits are read;
wherein the interleaving unit (1002) is specifically configured to:
read out the bits column by column in a reading manner of alternating a positive order and a reversal order, until the M bits are read;
wherein the reading manner of the positive order is a top-down reading of a column, and wherein the reading manner of the reversal order is a bottom-up reading of a column; and
wherein the reading manner of alternating the positive order and the reversal order comprises: a reading manner of the reversal order first and then the positive order.

3. A computer storage medium, wherein the computer storage medium stores a computer program, and the computer program comprises an instruction, which, when executed on a computer, causes the computer to perform the method according to claim 1.

4. A computer program product comprising an instruction, which, when executed on a computer, causes the computer to perform the method according to claim 1.

## Patentansprüche

1. Computerimplementiertes Verschachtelungsverfahren, umfassend:
Erlangen (601) von codierten Bits nach einer Polarcode-Codierung und Sortieren (601) der codierten Bits basierend auf einer Prioritätsreihenfolge der Durchführung eines Ratenabgleichvorgangs, um eine erste Bitfolge zu erlangen, wobei die erste Bitfolge N Bits umfasst, die erste Bitfolge j Teilfolgen umfasst und j eine positive ganze Zahl ist; und
Schreiben (602) der ersten Bitfolge in einen Verschachteler mit i Zeilen und j Spalten, wobei die Bits in einer Spalte des Verschachtelers eine der j Teilfolgen umfassen und i eine positive ganze Zahl ist; und Auslesen (603) der Bits spaltenweise aus dem Verschachteler, bis M Bits ausgelesen sind, wobei M eine Zielcodelänge eines Polarcodes ist;
wobei, falls es sich bei der Art des Ratenabgleichs um Punktierung handelt, die Prioritätsreihenfolge der Durchführung des Ratenabgleichvorgangs eine absteigende Reihenfolge der Möglichkeit ist, dass die codierten Bits punktiert werden, oder, falls es sich bei der Art des Ratenabgleichs um Verkürzung handelt, die Prioritätsreihenfolge der Durchführung des Ratenabgleichvorgangs eine absteigende Reihenfolge der Möglichkeit ist, dass die codierten Bits verkürzt werden;
wobei mindestens zwei benachbarte Spalten entgegengesetzte Ausleserichtungen aufweisen;
wobei, falls es sich bei der Art des Ratenabgleichs um Punktierung handelt, das spaltenweise Auslesen (603) von Bits aus dem Verschachteler, bis M Bits gelesen sind, Folgendes umfasst: Überspringen von P Bitpositionen, beginnend mit dem ersten Bit der ersten Spalte des Verschachtelers und spaltenweises Auslesen der Bits außer den Bits an den P Bitpositionen, beginnend mit einem (P+1) 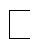 ten Bit, bis die M Bits gelesen sind; und
wobei, falls es sich bei der Art des Ratenabgleichs um Verkürzung handelt, das spaltenweise Auslesen (603) von Bits aus dem Verschachteler, bis M Bits gelesen sind, Folgendes umfasst: Überspringen von P Bitpositionen, beginnend mit dem letzten Bit einer j□ten Spalte des Verschachtelers und spaltenweises Auslesen der Bits außer den Bits an den P Bitpositionen, beginnend mit einem (P+1) 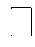 ten Bit, bis die M Bits gelesen sind; wobei das spaltenweise Auslesen (603) der Bits, bis die M Bits gelesen sind, Folgendes umfasst:
spaltenweises Auslesen der Bits in abwechselnder positiver und umgekehrter Lesereihenfolge, bis die M Bits gelesen sind;
wobei es sich bei der positiven Lesereihenfolge um ein Lesen einer Spalte von oben nach unten handelt und es sich bei der umgekehrten Lesereihenfolge um ein Lesen einer Spalte von unten nach oben handelt; und
wobei die abwechselnd positive und umgekehrte Lesereihenfolge Folgendes umfasst: zuerst die umgekehrte Lesereihenfolge und dann die positive Lesereihenfolge.

2. Verschachtelungseinrichtung (1000), umfassend:
eine Erlangungseinheit (1001), die dazu konfiguriert ist, codierte Bits nach einer Polarcode-Codierung zu erlangen und die codierten Bits basierend auf einer Prioritätsreihenfolge der Durchführung eines Ratenabgleichvorgangs zu sortieren, um eine erste Bitfolge zu erlangen, wobei die erste Bitfolge N Bits umfasst, die erste Bitfolge j Teilfolgen umfasst und j eine positive ganze Zahl ist; und
eine Verschachtelungseinheit (1002), die dazu konfiguriert ist, die erste Bitfolge in einen Verschachteler mit i Zeilen und j Spalten zu schreiben, wobei die Bits in einer Spalte des Verschachtelers eine der j Teilfolgen umfassen; und
die Bits spaltenweise aus dem Verschachteler auszulesen, bis M Bits gelesen sind, wobei M eine Zielcodelänge eines Polarcodes ist;
wobei, falls es sich bei der Art des Ratenabgleichs um Punktierung handelt, die Prioritätsreihenfolge der Durchführung des Ratenabgleichvorgangs eine absteigende Reihenfolge der Möglichkeit ist, dass die codierten Bits punktiert werden, oder, falls es sich bei der Art des Ratenabgleichs um Verkürzung handelt, die Prioritätsreihenfolge der Durchführung des Ratenabgleichvorgangs eine absteigende Reihenfolge der Möglichkeit ist, dass die codierten Bits verkürzt werden;
wobei mindestens zwei benachbarte Spalten entgegengesetzte Ausleserichtungen aufweisen;
wobei, falls es sich bei der Art des Ratenabgleichs um Punktierung handelt, die Verschachtelungseinheit (1002) dazu konfiguriert ist, P Bitpositionen, beginnend mit dem ersten Bit der ersten Spalte des Verschachtelers, zu überspringen, und spaltenweises Auslesen der Bits außer den Bits an den P Bitpositionen, beginnend mit einem (P+1) 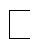 ten Bit, bis die M Bits gelesen sind; und
wobei, falls es sich bei der Art des Ratenabgleichs um Verkürzung handelt, die Verschachtelungseinheit (1002) dazu konfiguriert ist, P Bitpositionen, beginnend mit dem letzten Bit einer j 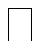 ten Spalte des Verschachtelers zu überspringen, und spaltenweises Auslesen der Bits außer den Bits an den P Bitpositionen, beginnend mit einem (P+1) 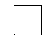 ten Bit, bis die M Bits gelesen sind; wobei die Verschachtelungseinheit (1002) speziell zu Folgendem konfiguriert ist:
spaltenweises Auslesen der Bits in abwechselnder positiver und umgekehrter Lesereihenfolge, bis die M Bits gelesen sind;
wobei es sich bei der positiven Lesereihenfolge um ein Lesen einer Spalte von oben nach unten handelt und es sich bei der umgekehrten Lesereihenfolge um ein Lesen einer Spalte von unten nach oben handelt; und
wobei die abwechselnd positive und umgekehrte Lesereihenfolge Folgendes umfasst: zuerst die umgekehrte Lesereihenfolge und dann die positive Lesereihenfolge.

3. Computerspeichermedium, wobei das Computerspeichermedium ein Computerprogramm speichert und das Computerprogramm eine Anweisung umfasst, die bei Ausführung auf einem Computer bewirkt, dass der Computer das Verfahren nach Anspruch 1 durchführt.

4. Computerprogrammprodukt, umfassend eine Anweisung, die bei Ausführung auf einem Computer bewirkt, dass der Computer das Verfahren nach Anspruch 1 durchführt.

## Revendications

1. Procédé d'entrelaçage mis en œuvre par ordinateur, comprenant :
l'obtention (601) de bits codés après codage en code polaire, et le tri (601) des bits codés sur la base d'un ordre de priorité d'exécution d'une opération d'adaptation de débit, pour obtenir une première séquence de bits, dans lequel la première séquence de bits comprend N bits, la première séquence de bits comprend j sous-séquences, et j est un entier positif ; et
l'écriture (602) de la première séquence de bits dans un entrelaceur de i lignes et j colonnes, dans lequel les bits d'une colonne de l'entrelaceur comprennent l'une des j sous-séquences, et i est un entier positif ; et la lecture (603) des bits de l'entrelaceur colonne par colonne, jusqu'à ce que M bits soient lus, dans lequel M est la longueur de code cible d'un code polaire ;
dans lequel, si le mode d'adaptation du débit est le puncturing, l'ordre de priorité d'exécution de l'opération d'adaptation du débit est un ordre décroissant de possibilité que les bits codés soient soumis au puncturing, ou si le mode d'adaptation du débit est le raccourcissement, l'ordre de priorité d'exécution de l'opération d'adaptation du débit est un ordre décroissant de possibilité que les bits codés soient raccourcis ;
dans lequel au moins deux colonnes adjacentes ont des directions de lecture opposées ;
dans lequel, si le mode d'adaptation du débit est le puncturing, la lecture (603) des bits de l'entrelaceur colonne par colonne, jusqu'à ce que M bits soient lus, comprend : l'omission de P emplacements de bits à partir du premier bit de la première colonne de l'entrelaceur, et la lecture des bits autres que les bits aux P emplacements de bits colonne par colonne en commençant par un (P+1)^{ème} bit, jusqu'à ce que les M bits soient lus ; et
dans lequel, si le mode d'adaptation du débit est le raccourcissement, la lecture (603) des bits de l'entrelaceur colonne par colonne, jusqu'à ce que M bits soient lus, comprend : l'omission de P emplacements de bits à partir du dernier bit d'une j^{ème} colonne de l'entrelaceur, et la lecture des bits autres que les bits aux P emplacements de bits colonne par colonne en commençant par un (P+1)^{ème} bit, jusqu'à ce que les M bits soient lus ;
dans lequel la lecture (603) des bits colonne par colonne, jusqu'à ce que les M bits soient lus, comprend :
la lecture des bits colonne par colonne selon un mode de lecture alternant un ordre positif et un ordre inverse, jusqu'à ce que les M bits soient lus ;
dans lequel le mode de lecture de l'ordre positif est une lecture de haut en bas d'une colonne, et dans lequel le mode de lecture de l'ordre inverse est une lecture de bas en haut d'une colonne ; et
dans lequel le mode de lecture alternant l'ordre positif et l'ordre inverse comprend : un mode de lecture commençant par l'ordre inversé, puis par l'ordre positif.

2. Appareil d'entrelaçage (1000), comprenant :
une unité d'obtention (1001) configurée pour obtenir des bits codés après codage en code polaire, et pour trier les bits codés sur la base d'un ordre de priorité d'exécution d'une opération d'adaptation de débit, pour obtenir une première séquence de bits, dans lequel la première séquence de bits comprend N bits, la première séquence de bits comprend j sous-séquences, et j est un entier positif ; et
une unité d'entrelaçage (1002), configurée pour : écrire la première séquence de bits dans un entrelaceur de i lignes et j colonnes, dans lequel les bits d'une colonne de l'entrelaceur comprennent l'une des j sous-séquences ; et
lire les bits de l'entrelaceur colonne par colonne, jusqu'à ce que M bits soient lus, dans lequel M est la longueur de code cible d'un code polaire ;
dans lequel, si le mode d'adaptation du débit est le puncturing, l'ordre de priorité d'exécution de l'opération d'adaptation du débit est un ordre décroissant de possibilité que les bits codés soient soumis au puncturing, ou si le mode d'adaptation du débit consiste est le raccourcissement, l'ordre de priorité d'exécution de l'opération d'adaptation du débit est un ordre décroissant de possibilité que les bits codés soient raccourcis ;
dans lequel au moins deux colonnes adjacentes ont des directions de lecture opposées ;
dans lequel, si le mode d'adaptation du débit est le puncturing, l'unité d'entrelaçage (1002) est configurée pour omettre P emplacements de bits à partir du premier bit de la première colonne de l'entrelaceur, et lire des bits autres que les bits aux P emplacements de bits colonne par colonne en commençant par un (P+1)^{ème} bit, jusqu'à ce que les M bits soient lus ; et
dans lequel, si le mode d'adaptation du débit est le raccourcissement, l'unité d'entrelaçage (1002) est configurée pour omettre P emplacements de bits à partir du dernier bit d'une j^{ème} colonne de l'entrelaceur, et lire des bits autres que les bits aux P emplacements de bits colonne par colonne en commençant par un (P+1)^{ème} bit, jusqu'à ce que les M bits soient lus ;
dans lequel l'unité d'entrelaçage (1002) est spécifiquement configurée pour :
lire les bits colonne par colonne selon un mode de lecture alternant un ordre positif et un ordre inverse, jusqu'à ce que les M bits soient lus ;
dans lequel le mode de lecture de l'ordre positif est une lecture de haut en bas d'une colonne, et dans lequel le mode de lecture de l'ordre inverse est une lecture de bas en haut d'une colonne ; et
dans lequel le mode de lecture alternant l'ordre positif et
l'ordre inverse comprend : un mode de lecture commençant par l'ordre inversé, puis par l'ordre positif.

3. Support de stockage informatique, dans lequel le support de stockage informatique stocke un programme informatique, et le programme informatique comprend une instruction qui, lorsqu'elle est exécutée sur un ordinateur, amène l'ordinateur à réaliser le procédé selon la revendication 1.

4. Produit de programme informatique comprenant une instruction qui, lorsqu'elle est exécutée sur un ordinateur, amène l'ordinateur à réaliser le procédé selon la revendication 1.
